Europäisches Patentamt

European Patent Office

Office européen des brevets

(19)

(11) Veröffentlichungsnummer: **0 081 208**
**B1**

(12)

# EUROPÄISCHE PATENTSCHRIFT

(45) Veröffentlichungstag der Patentschrift:
16.09.87

(21) Anmeldenummer: 82111172.1

(22) Anmeldetag: 02.12.82

(51) Int. Cl.⁴: **G 11 C 11/40**

(54) **Statische Speicherzelle.**

(30) Priorität: 03.12.81 DE 3147951

(43) Veröffentlichungstag der Anmeldung:
15.06.83 Patentblatt 83/24

(45) Bekanntmachung des Hinweises auf die Patenterteilung:
16.09.87 Patentblatt 87/38

(84) Benannte Vertragsstaaten:
AT DE FR GB IT

(56) Entgegenhaltungen:
DE - A - 2 711 221
FR - A - 2 449 973

(73) Patentinhaber: **Siemens Aktiengesellschaft Berlin und München, Wittelsbacherplatz 2, D-8000 München 2 (DE)**

(72) Erfinder: **Scianna, Cosimo, Dr., Fondo Ramacca, I-90011 Bagheria (Palermo) (IT)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine statische Speicherzelle nach dem Oberbegriff des Anspruchs 1.

Entsprechende auch als «Depletion Load»-Speicherzellen bezeichnete, in MOS-Technik hergestellte Random-Acces-Memories (RAM's) sind z.B. aus W. Söll, J.-H. Kirchner, Digitale Speicher, Vogel-Verlag, 1978, S. 132 und 133 bekannt. Die Stromaufnahme entsprechender statischer RAM's soll insbesondere im Standby-Betrieb klein gehalten werden. Dies erfordert jedoch wegen der dann notwendigen grossen Lastelemente eine erhebliche Erhöhung des Flächenbedarfs einer Speicherzelle. Ein geringerer Energieverbrauch ist insbesondere auch dann von Bedeutung, wenn die Informationen der RAM-Zellen auch bei einem kurzen Netzausfall erhalten bleiben sollen und aus diesem Grunde die Zellen während des Stromausfalls von einem externen Kondensator versorgt werden.

Zur Verringerung des Stromverbrauches statischer RAM-Zellen ist es aus IEEE Journal of Solid-State Circuits, VOL. SC-15, No. 5, October 1980, S. 826 bis 830 bekannt, die Lastelemente als nicht dotierte Polysilicium-Widerstände auszuführen. Dies erfordert jedoch zusätzliche technologische Schritte bei der Herstellung der RAM-Zellen.

Aufgabe der vorliegenden Erfindung ist es hier Abhilfe zu schaffen, und eine statische Speicherzelle zu schaffen, die bei geringem Flächenbedarf verlustleistungsarm ist.

Diese Aufgabe wird bei einer Speicherzelle der eingangs genannten Art dadurch gelöst, dass zwischen der Sourceelektrode des Depletion-Transistors und dem Ausgangsknoten jedes Inverters eine zusätzliche Potentialquelle geschaltet ist wodurch der durch die Inverter fliessende Strom verringert wird. Durch die als Sourcevorspannung wirkende zusätzliche Potentialquelle verändert sich die Einsatzspannung des Depletion-Transistors, wodurch einerseits eine Verschiebung der sogenannten Depletion-Kurve und somit eine Stromabnahme verursacht wird. Die Gateelektrode des Depletion-Transistors wird andererseits bezüglich der Source-Elektrode negativ, so dass der Strom weiter abnimmt.

In technologisch einfacher Weise ist die Potentialquelle durch einen Enhancement-Transistor, dessen Gateelektrode mit der Drainelektrode verbunden ist, zu realisieren.

Ausgestaltungen der erfindungsgemässen Speicherzelle sind in Unteransprüchen gekennzeichnet.

Die Erfindung wird im folgenden an Hand der Figuren näher erläutert. Es zeigen:

Fig. 1 eine statische Speicherzelle nach dem Stand der Technik,

Fig. 2 die schaltungstechnische Anordnung der erfindungsgemässen zusätzlichen Potentialquelle,

Fig. 3 die erfindungsgemäss erreichte Verschiebung der Depletion-Kurve und

Fig. 4 das Schaltbild eines Ausführungsbeispiels einer erfindungsgemässen Speicherzelle.

In den Figuren sind gleiche Elemente mit gleichen Bezugzeichen versehen.

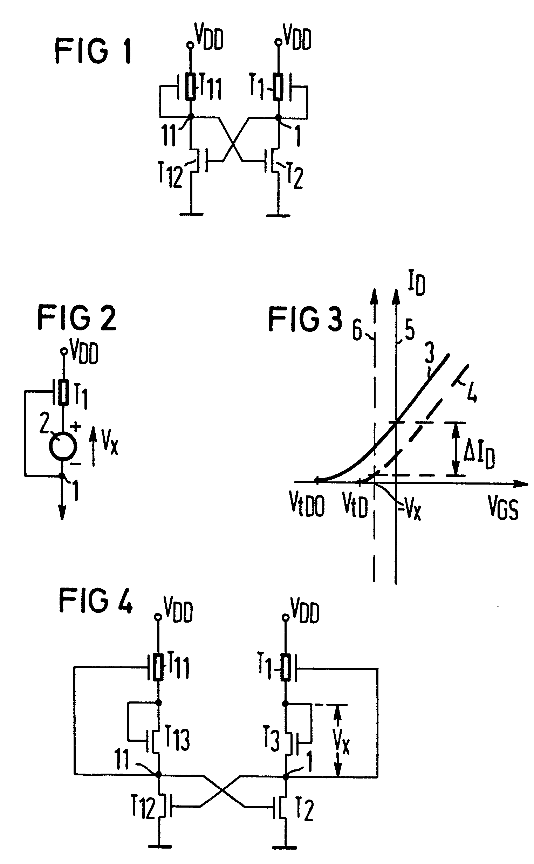

Die Fig. 1 zeigt eine statische Speicherzelle nach dem Stand der Technik, die z.B. in Silicon-Gate-Depletion-Mode-Technologie hergestellt sein kann. Die Speicherzelle weist einen ersten aus dem Depletion-Transistor T1 und aus dem als Enhancement-Typ ausgeführten Schalttransistor T2 bestehenden Inverter und einen zweiten, analog zum ersten Inverter aus Depletion-Transistor T11 und Schalttransistor T12 bestehenden Inverter auf. Die Drain-Elektrode des Depletion-Transistors T1 ist mit der Betriebsspannung $V_{DD}$ verbunden. Die Source-Elektrode und die Gateelektrode des Depletion-Transistors T1 sind mit der Drainelektrode des Schalttransistors T2 am Ausgangsknoten 1 verbunden. Die Sourceelektrode des Schalttransistors T2 liegt an Masse. Für den zweiten, aus den Transistoren T11 und T12 gebildeten Inverter gilt entsprechendes.

Durch die kreuzweise Verbindung der Gate- und der Drainanschlüsse der Schalttransistoren T2 und T12 ergibt sich in bekannter Weise die Arbeitsweise eines Flip-Flops mit zwei stabilen Betriebszuständen.

Der Strom durch einen in Sättigung betriebenen Depletion-Transistor T1 berechnet sich nach:

$$I_D = \frac{1}{2} K_D \frac{W_D}{L_D} (V_{GS} - V_{tD})^2 \qquad (1)$$

mit

$K_D$: Depletion-Steuerfaktor (geometrie- und materialabhängige Konstante)
$W_D$: Kanalbreite des Depletion-Transistors
$L_D$: Kanallänge des Depletion-Transistors
$V_{GS}$: Gate-Source-Spannung
$V_{tD}$: Einsatzspannung des Depletion-Transistors.

Die Einsatzspannung $V_{tD}$ des Depletion-Transistors T1 hängt von der Source-Spannung $V_x$, d.h. der zwischen Source und Substrat liegenden Spannung wie folgt ab (angenommen $V_{BB} = 0$, d.h. Substrat mit Masse verbunden):

$$V_{tD} = V_{tDO} + F_D ( \sqrt{V_x + 2\emptyset_F} - \sqrt{2\emptyset_F})$$

Mit $V_{tDO}$: Einsatzspannung des Depletion-Transistors bei Source-Spannung 0
$F_D$: Substratsteuerfaktor des Depletion-Transistors,
$\emptyset_F$: Fermipotential.

Will man den Strom durch Verlängerung der Kanallänge verringern, so werden lange Transistoren benötigt, was einen erhöhten Flächenbedarf erfordert. Schaltet man nun erfindungsgemäss zwischen die Source-Elektrode des Depletion-Transistors T1 und den Ausgangsknoten 1 eine zusätzliche Potentialquelle 2 mit dem Potential $V_x$, die entsprechend dem Depletion-Transistor T1 gepolt ist, d.h. bei n-Kanal-Technologie zur Source-Elektrode des Depletion-Transistors T1 hin positiv gepolt ist (Fig. 2), so wird sowohl die Einsatzspannung $V_{tD}$ positiver als auch die Gate-Spannung $V_{GS}$ negativer, so dass gemäss Gleichung (1) der Strom in zweifacher Weise verringert wird.

Dies verdeutlicht die Fig. 3, die die Depletion-Kurve, d.h. die Abhängigkeit des Stromes $I_D$ von der Gate-Source-Spannung $V_{GS}$ darstellt. Das zusätzliche Potential $V_x$ hat zwei sich addierende Wirkungen: Zum ersten verändert es als Source-vorspannung die Einsatzspannung $V_{tDO}$, was eine Verschiebung der Depletion-Kurve nach rechts (von 3 nach 4) und daher eine Stromabnahme verursacht.

Zum anderen wird das Gate bezüglich der Source negativ, die Ordinatenachse wird somit nach links verschoben (von 5 nach 6), so dass der Strom $L_D$ weiter abnimmt. Die gesamte, durch die zusätzliche Potentialquelle $V_x$ bewirkte Änderung des Stromes $I_D$ ist mit $\Delta I_D$ bezeichnet.

Als zusätzliche Potentialquelle $V_x$ kann z.B. jede beliebige Spannungsquelle, wie z.B. eine Batterie verwendet werden. Wirtschaftlich günstig und technologisch einfach kann der zusätzliche Spannungsabfall in der Weise realisiert werden, dass, wie in der Fig. 4 gezeigt, zwischen dem Ausgangsknoten 1 des aus Transistor T1 und T2 bestehenden ersten Inverters ein Enhancement-Transistor T3 geschaltet wird, dessen Gate-Elektrode mit seiner Drain-Elektrode verbunden ist. Entsprechend wird zwischen den Ausgangsknoten 11 des aus den Transistoren T11 und T12 bestehenden zweiten Inverters und der Source-Elektrode des Transistors T11 ein Enhancement-Transistor T13 geschaltet.

Um die Leitfähigkeit des Depletion-Transistors T1 bzw. des Depletion-Transistors T11 immer zu gewährleisten muss

$$V_{tD} + V_x < 0 \text{ sein.}$$

Die Lösung dieser Ungleichung ergibt:

$$V_x < V_{x2} \tag{2}$$

wobei

$$V_{x2} = \frac{-(2T - F_D{}^2) - \sqrt{(2T - F_D{}^2)^2 - 4(T^2 - 2\emptyset_F F_D{}^2)}}{2}$$

und $T = V_{tDO} - F_D \sqrt{2\emptyset_F}$ ist.

Wird der Spannungsabfall $V_x$, wie in der Fig. 4 gezeigt, durch einen Enhancement-Transistor T3 bzw. T13 erzeugt, so gilt für T3:

$$I_E = \frac{1}{2} K_E \frac{W_E}{L_E} (V_x - V_{tE})^2 \tag{3}$$

mit

$I_E$: Strom durch den Enhancement-Transistor
$K_E$: Steuerfaktor des Enhancement-Transistors
$W_E$: Kanalbreite des Enhancement-Transistors
$L_E$: Kanallänge des Enhancement-Transistors
$V_{tE}$: Einsatzspannung des Enhancement-Transistors.

Sperrt der Schalttransistor $T_2$, so muss dafür gesorgt werden, dass die Spannung $V_x$ am Enhan-cement-Transistor T3, die etwa der Einsatzspannung $V_{tE}$ entspricht, der Ungleichung (2) genügt:

$$V_{tE} = V_x < V_{x2}$$

Wenn der Schalttransistor T2 leitend wird, ist

$$V_x \geqslant V_{tE} \simeq V_{tEO}$$

wobei die Restspannung am Schalttransistor T2 vernachlässigt wird und $V_{tEO}$ die Einsatzspannung des Enhancement-Transistors bei Source-Spannung Null bedeutet.

Als zur Dimensionierung des Enhancement-Transistors T3 zu beachtende Grenzwerte für die Spannung $V_x$ bzw. die Drain-Source-Spannung des Transistors T3 ergeben sich dann die Grenzwerte:

$$V_{tEO} < V_x < V_{x2} \tag{8}$$

Im einzelnen können die Transistoren T1 und T3 bzw. T11 und T13 wie folgt dimensioniert werden: Für den vorgegebenen Strom I, der in die Zelle fliessen darf gilt

$$I = I_D = I_E.$$

Nimmt man für die Transistoren T1 und T3 beispielsweise gleiche Kanalbreiten ($W = W_D = W_E$) an, so lassen sich aus (1) und (3) die Längen der Transistoren wie folgt ableiten:

$$L_D = \frac{1}{2} K_D \frac{W}{I} (-V_x - V_{tD})^2 \tag{6}$$

$$L_E = \frac{1}{2} K_E \frac{W}{I} (V_x - V_{tE})^2 \tag{7}$$

Eine optimale Längenkombination von $L_D$ (Kanallänge von T1) und $L_E$ (Kanallänge von T3) liefert eine minimale Gesamtlänge L, wobei $L = L_D + L_E$. Man sucht nun für dieses Minimale L das betreffende $V_x$ (innerhalb der obengenannten Grenzwerte). $V_x$ genügt folgender Gleichung:

$$\frac{\delta L}{\delta V_x} = 0$$

$$\frac{\delta L}{\delta V_x} = K_D \frac{W}{I} \left[ -V_x - V_{tDO} - F_D \left( \sqrt{V_x + 2\emptyset_F} - \sqrt{2\emptyset_F} \right) \right] \cdot$$

$$\left[ -1 - \frac{1}{2} F_D (V_x + 2\emptyset_F)^{-1/2} \right] + K_E \frac{W}{I} (V_x - V_{tE}).$$

Durch Nullsetzen erhält man:

$$K_D \left[ -V_x - V_{tDO} - F_D \left( \sqrt{V_x + 2\emptyset_F} - \sqrt{2\emptyset_F} \right) \right]$$

$$\left[ -1 - \frac{1}{2} F_D (V_x + 2\emptyset_F)^{-1/2} \right] + K_E (V_x - V_{tE}) = 0.$$

Sortieren nach Potenzen ergibt:

$$\frac{AV_x + B}{CV_x + D} = \sqrt{V_x + 2\emptyset_F} \qquad (5)$$

mit

$A = 3/2\ F_D K_D,\ B = 1/2\ K_D F_D\ (4\emptyset_F + V_{tDO} - F_D\ \sqrt{2\emptyset_F})$,

$C = K_D + K_E,\ D = K_D\ (V_{tDO} - F_D\ \sqrt{2\emptyset_F} + 1/2\ F_D{}^2)$

$\qquad\qquad - K_E\ V_{tE}$

Durch Interpolation dieser Kurve (5) innerhalb der obengenannten Grenzwerte (Gleichung (8)) ist festzustellen, dass sie nach Null tendiert und der entsprechende $V_x$-Wert ein Minimum für L ist.

Dieser Wert bestimmt durch (6) und (7) die zwei Längen $L_D$, $L_E$ und ist unabhängig sowohl von dem Strom, der durch den Zweig fliesst, als auch von der Weite W, wenn sie gleich für beide Transistoren gewählt wird. Die Kanalweite beider Transistoren kann jedoch selbstverständlich auch unterschiedlich gewählt werden.

Dimensionierungsbeispiel in NMOS-Silicon-Gate-Depletion-Mode-Technologie:

$I\qquad = 10\ \mu A$
$V_{tDO}\quad = -3,7\ V$
$K_D\qquad = 30\ \mu A/V^2$
$V_{tEO}\quad = 0,7\ V$
$K_E\qquad = 36\ \mu A/V^2$
$F_D\qquad = 0,4\ V^{1/2}$
$2\emptyset_F\quad = 0,7\ V$

$V_x$-Grenzwerte: 0,7 bis 3,22 V
$V_x\ = 1,944\ V$
$L_D = 10,77 \rightarrow 11\ \mu m \qquad W_D = 5\ \mu m$
$L_E = 15,07 \rightarrow 15\ \mu m \qquad W_E = 5\ \mu m$

$L_D + L_E = 26\ \mu m$

Um den Strom durch einen in Sättigung betriebenen Depletion-Transistor T1 nach Fig. 1 (Stand der Technik) auf 10 μA zu begrenzen muss der Kanal des Transistors T1 dagegen 103 μm lang, d.h. annähernd den Faktor 4 länger, dimensioniert werden.

**Patentansprüche**

1. Statische Speicherzelle aus zwei rückgekoppelten Invertern, bei der jeder Inverter aus einem Schalttransistor (T2, T12) und einem als Depletion-Transistor ausgeführten Lastelement (T1, T11) besteht und bei der die Verbindung der Drainelektrode des Schalttransistors mit der Gateelektrode des Depletion-Transistors jedes Inverters einen Ausgangsknoten (1, 11) bildet, dadurch gekennzeichnet, dass zwischen der Sourceelektrode des Depletion-Transistors (T1, T11) und dem Ausgangsknoten (1, 11) jedes Inverters eine zusätzliche Potentialquelle (2) geschaltet ist, wodurch der durch die Inverter fliessende Strom verringert wird.

2. Speicherzelle nach Anspruch 1, dadurch gekennzeichnet, dass als zusätzliche Potentialquelle (2) ein Enhancement-Transistor (T3, T13), dessen Gateelektrode mit der Drainelektrode verbunden ist, vorgesehen ist.

3. Speicherzelle nach Anspruch 1 oder 2, dadurch gekennzeichnet, dass der Enhancement-Transistor (T3) so ausgeführt ist, dass seine sich zwischen Drainelektrode und Sourceelektrode ausbildende Spannung im Bereich zwischen $V_{tEO}$ und $V_{x2}$ liegt, mit
$V_{tEO} =$ Einsatzspannung des Enhancement-Transistors bei Sourcespannung gleich Null,

$$V_{x2} = \frac{-(2T - F_D{}^2) - \sqrt{(2T - F_D{}^2)^2 - 4\ (T^2 - 2\emptyset_F\ F_D{}^2)}}{2},$$

wobei

$$T = V_{tDO} - F_D\ \sqrt{2\emptyset_F}\ ,$$

$F_D$: Substratsteuerfaktor eines Depletion-Transistors,
$\emptyset_F$: Fermipotential,
$V_{tEO}$: Einsatzspannung des Depletion-Transistors bei Sourcespannung gleich Null.

**Claims**

1. A static storage cell comprising two feedback inverters, each of which inverters consists of a switching transistor (T2, T12) and a depletion transistor forming a load element (T1, T11), and the connection of the drain electrode of the switching transistor to the gate electrode of the depletion transistor of each inverter forms an output node (1, 11) characterised in that an additional potential source (2) is connected between the source electrode of the deplection transistor (T1, T11) and the output node (1, 11) of each inverter, as a result of which the current flowing through the inverters is reduced.

2. A storage cell as claimed in Claim 1, characterised in that the additional potential source (2) consists of an enhancement transistor (T3, T13) whose gate electrode is connected to the drain electrode.

3. A storage cell as claimed in Claim 1 or 2, characterised in that the enhancement transistor (T3) is designed such that the voltage occurring between its drain electrode and source electrode ranges between $V_{tEO}$ and $V_{x2}$, where:
$V_{tEO} =$ the start voltage of the enhancement transistor at a source voltage of zero; and

$$V_{x2} = \frac{-(2T - F_D{}^2) - \sqrt{(2T - F_D{}^2)^2 - 4\ (T^2 - 2\emptyset_F\ F_D{}^2)}}{2},$$

where:

$$T = V_{tDO} - F_D\ \sqrt{2\emptyset_F}\ ;$$

$F_D$:    the substrate control factor of a depletion transistor;

$\emptyset_F$:    the Fermi potential; and

$V_{tEO}$:    the start voltage of the depletion transistor at a source voltage of zero.

### Revendications

1. Cellule de mémoire statique constituée par deux inverseurs couplés par réaction et dans laquelle chaque inverseur est constitué par un transistor de cummutation (T2, T12) et par un élément de charge (T1, T11) réalisé sous la forme d'un transistor à appauvrissement, et dans laquelle la liaison de l'électrode de drain du transistor de commutation avec l'électrode de grille du transistor à appauvrissement de chaque inverseur forme un nœud de sortie (1, 11), caractérisée par le fait qu'entre l'électrode de source du transistor à appauvrissement (T1, T11) et le nœud de sortie (1, 11) de chaque inverseur se trouve branchée une source de potentiel supplémentaire (2), ce qui a pour effet que le courant traversant l'inverseur est réduit.

2. Cellule de mémoire selon la revendication 1, caractérisée par le fait qu'il est prévu, en tant que source de potentiel supplémentaire (2), un transistor à enrichissement (T3, T13), dont l'électrode de grille est reliée à l'électrode de drain.

3. Cellule de mémoire suivant la revendication 1 ou 2, caractérisée par le fait que le transistor à enrichissement (T3) est réalisé de telle sorte que sa tension, qui s'établit entre l'électrode de drain et l'électrode de source, est située dans la gamme comprise entre $V_{tEO}$ et $V_{x2}$, avec

$V_{tEO}$ = Tension de déclenchement du transistor à enrichissement pour une tension de source nulle,

$$V_{x2} = \frac{-(2T - F_D{}^2) - \sqrt{(2T - F_D{}^2)^2 - 4\,(T^2 - 2\emptyset_F\,F_D{}^2)}}{2},$$

avec

$$T = V_{tDO} - F_D\sqrt{2\emptyset_F},$$

$F_D$:    facteur de commande du substrat d'un transistor à appauvrissement,

$\emptyset_F$:    potentiel de Fermi

$V_{tEO}$:    tension de déclenchement du transistor à appauvrissement pour une tension de source nulle.

FIG 1

FIG 2

FIG 3

FIG 4